# EUROPEAN PATENT APPLICATION

(11) **EP 1 605 518 A2**
(43) Date of publication of application: **14.12.2005**
(21) Application number: 05012020.3
(22) Date of filing: 03.06.2005
(51) Int. Cl.: H01L 29/866, H01L 21/329

(54) **Zener diode and method for fabricating the same**

(30) Priority: 10.06.2004 KR 2004042724
(71) Applicant: LG Electronics, Inc., Seoul 150-875 (KR)
(72) Inventor: Kim, Geun Ho, Gangnam-gu Seoul, 135-960 (KR); Lee, Seung Yeob, No. 402, Jeongseokgreenbilla, Seongnam-si Gyeonggi-do 462-837 (KR)
(74) Representative: Zech, Stefan Markus

(57) **Abstract**

The present invention is directed to a Zener diode and a method for fabricating the same. According to the present invention, a voltage regulator device can be fabricated by carrying out a diffusion process without using a diffusion mask. Further, a PNP (or NPN) Zener diode having a bi-directional threshold voltage characteristic or a PN Zener diode can be fabricated without any photolithographic process or using the minimum number of processes. Therefore, the number of processing steps can be reduced and the yield thereof can be increased.

## Description

### BACKGROUND OF THE INVENTION

### 1. Field of the Invention

The present invention relates to a Zener diode used as a voltage regulator device and a method for fabricating the same. In particular, the invention relates to a Zener diode and a method for fabricating the same, capable of generating the Zener breakdown without a diffusion mask required for selective diffusion.

### 2. Description of the Related Art

In general, a light emitting device such as a light emitting diode or laser diode, in which a group III - V compound semiconductor material of a direct transition type semiconductor, has come to generate a variety of colored lights including green, blue, ultraviolet and the like, due to the advancement in the field of thin film growth technologies and semiconductor materials.

In addition, a white light with good efficiency can also be implemented by using a fluorescence material or combining a variety of colors.

According to these technological advancement, the light emitting device comes to have a wide range of applications such as a transmission module for optical-communication system, an LED (light emitting diode) backlight capable of substituting for the cold cathode fluorescence lamp (CCFL) constituting the backlight of a liquid crystal display (LCD) device, a white LED system capable of substituting for a fluorescent lamp or incandescent lamp, and a traffic light, in addition to a display device.

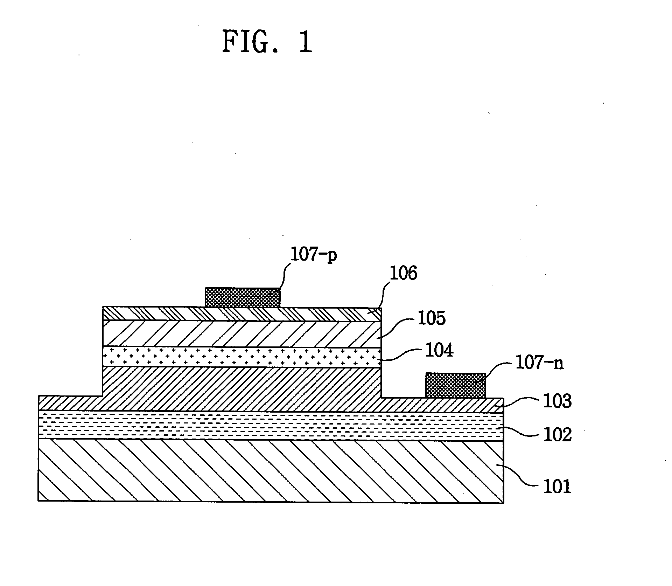

Fig. 1 is a sectional view of a general LED device. In order to fabricate this LED device, a buffer layer 102, an n-contact layer 103, an n-cladding layer (not shown), an active layer 104, a p-cladding layer (not shown), and a p-contact layer 105 are sequentially deposited on the top of a substrate 101 made of sapphire, n-GaAs, GaN or the like, using a chemical vapor deposition process.

Thereafter, a mesa etching is carried out to expose the n-contact layer 103, through a photolithographic etching process and a dry/wet etching process.

Next, on the top of the p-contact layer 105 is formed a current diffusion layer 106, which is formed of a transparent electrode with good light transmission. For an electrical connection with an external circuit, a p-electrode 107-p and an n-electrode 107-n are formed on the current diffusion layer 106 and the n-contact layer 103, respectively, thereby forming a LED device 100.

That is, when a voltage from an external circuit is applied between the p-electrode 107-p and the n-electrode 107-n in this light-emitting device, positive holes and electrons are injected into the p-electrode 107-p and the n-electrode 107-n. While the positive holes and the electrons are recombined in the active layer 104, extra energy is converted into light, which in turn is emitted to the outside through the current diffusion layer and the substrate.

In the meantime, if static electricity or surge voltage is produced in this type of light emitting device, an excessive electric charge flows into the semiconductor layers and finally causes failure of the light emitting device.

This problem becomes worse in a case where the devices are fabricated on the top of a dielectric substrate. When the surge voltage is produced in the device, an applied voltage may rise up to a few thousands volts. Thus, when a light emitting device has a low withstand voltage (allowable voltage), an additional protective device should be installed.

As the protective device, for example, a plurality of general diodes are connected in series such that the diodes can be turned on at a voltage higher than the driving voltage of the light emitting device.

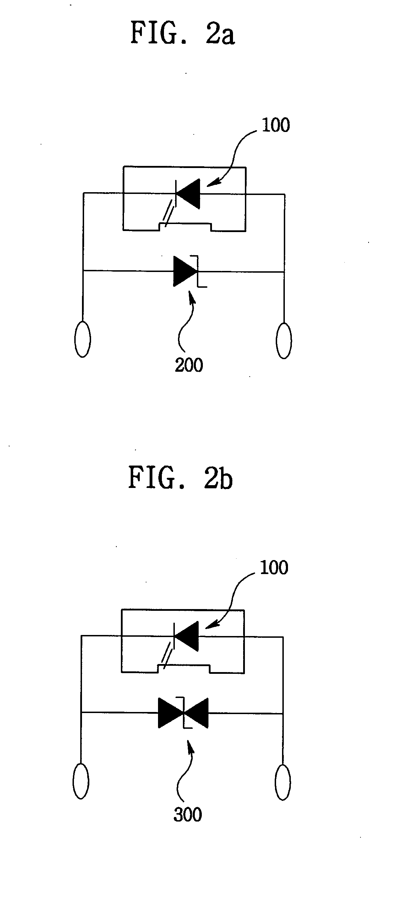

Therefore, as shown in Figs. 2a and 2b, a PN or PNP (NPN) Zener diode 200 or 300, which is used as a constant voltage device, is connected to a light emitting device 100 in such a manner that their opposite electrodes are connected to each other. Thus, the voltage applied to the light emitting device is restricted to Vz (Zener voltage) of the Zener diode.

That is, if the reverse voltage of the Zener diode is equal to or greater than Vz, the reverse current (a current flowing from the n-electrode towards the p-electrode) increases and the terminal voltage between both ends of the Zener diode remains almost constant, i.e. Vz.

In this way, a Zener diode is not only used as a protective device but also is widely used as a voltage regulator device for maintaining a load voltage to be constant against variation in an input voltage or load.

Such a Zener diode as a protective device is fabricated separately from the device, such as a light emitting device, to be protected and is then electrically connected thereto in parallel. Alternatively, the light emitting device and the Zener diode may be connected on a silicon sub-mount by means of a flip chip bonding.

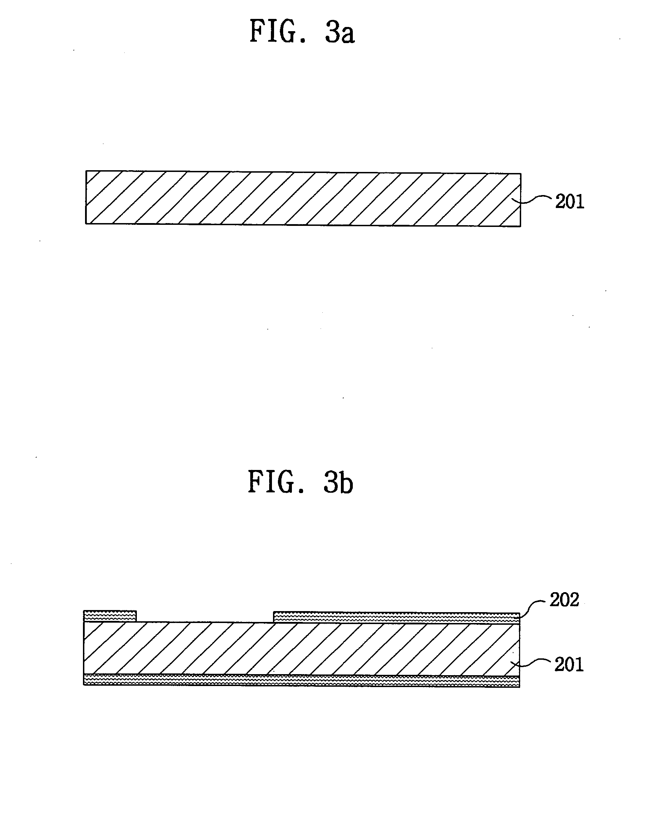

Figs. 3a to 3g are sectional views explaining a process of fabricating a conventional PN Zener diode. Figs. 3a and 3b show a process of using a diffusion mask.

First, a Zener diode is a device that utilizes the tunneling effect in quantum mechanics, and thus, a substrate 201 with low resistance must be used. Since Vz (Zener voltage) of the device is determined by the electrical resistivity of the substrate and the concentration of diffused impurities thereof, a substrate with an appropriate concentration of impurities contained therein must be used (Fig. 3a).

Further, in order to selectively diffuse impurities into the substrate, a diffusion mask 202 (a silicon oxide film is generally employed) is deposited on the top and bottom surfaces of the substrate. Then, the diffusion mask deposited on the top surface of the substrate is selectively etched and then patterned (Fig. 3b).

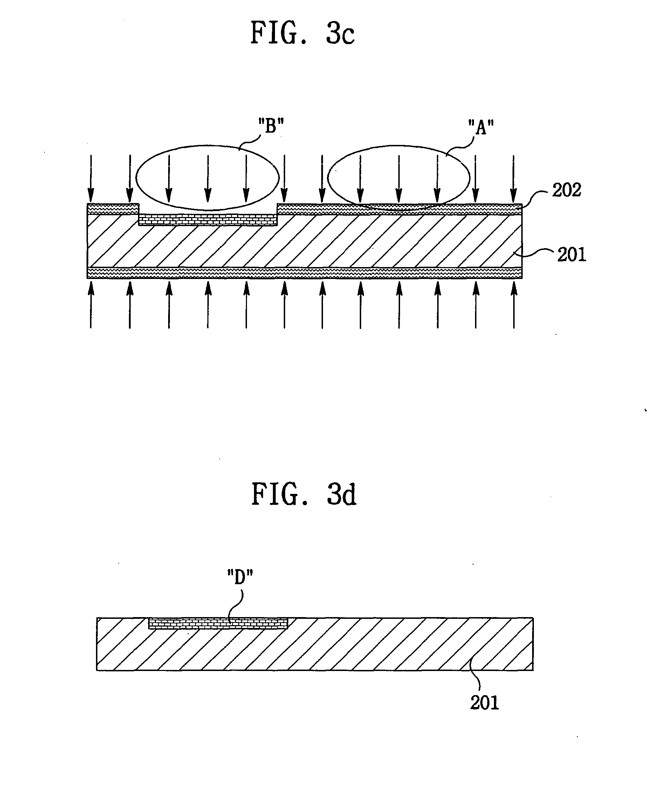

Fig. 3c shows a diffusion step. After patterning the diffusion mask, a diffusion process is carried out. Different types of impurities from those in the substrate are injected into the substrate through a portion (portion " B") where the diffusion mask has been etched. The impurity injection process can utilize a diffusion process and an ion injection process using a furnace.

Here, impurities are not injected into the substrate through a portion " A" where the diffusion mask remains.

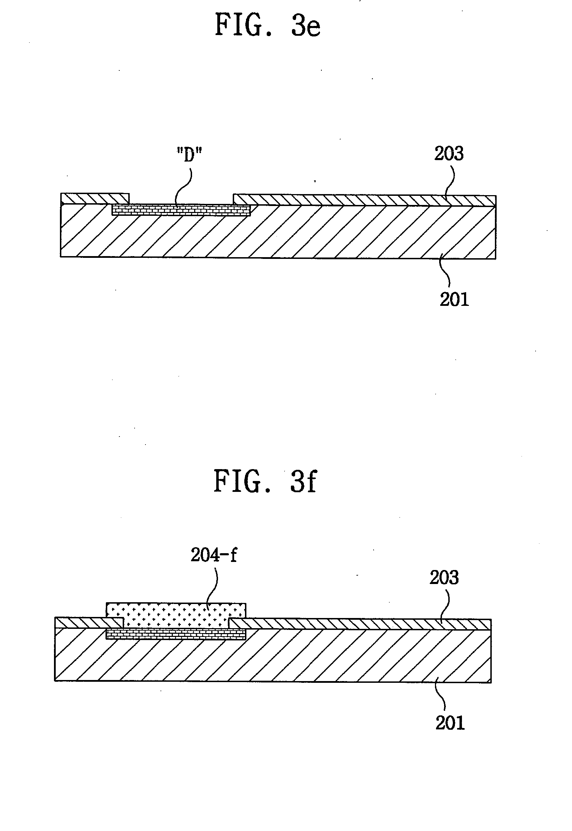

Thereafter, the diffusion mask is removed (Fig. 3d), and a protective film 203 is deposited on the top surface of the substrate 201. Then, the diffusion area D of the substrate 201 is exposed (Fig. 3e).

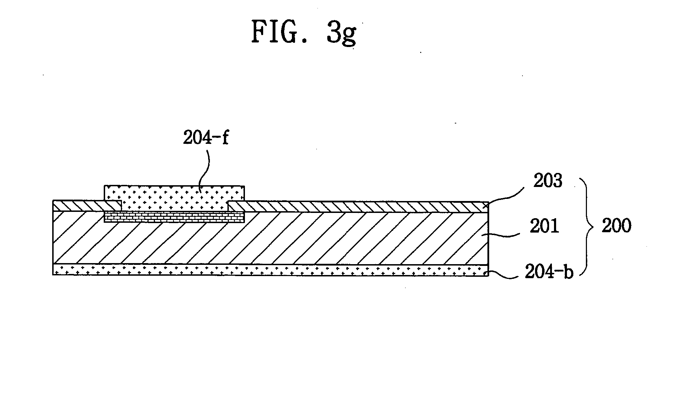

Finally, as shown in Figs. 3f and 3g, on the top surface of the exposed diffusion area D of the substrate 201 is formed an electrode 204-f, and on the bottom surface of the substrate 201 is formed an electrode 204-b. Consequently, a Zener diode 200 is fabricated.

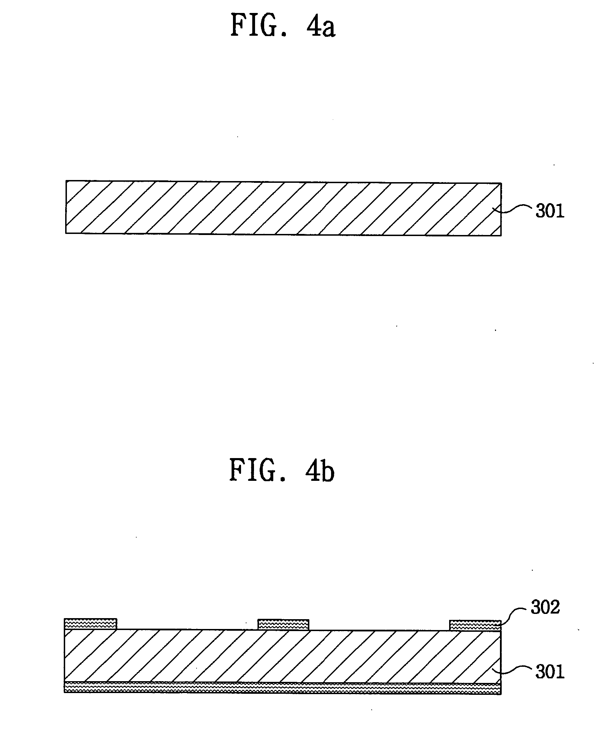

Figs. 4a to 4f are sectional views explaining a process of fabricating a conventional PNP (NPN) Zener diode. A substrate 301 with an appropriate concentration of impurities contained therein is first prepared (Fig.4a). In order to selectively diffuse impurities into the substrate 301, a diffusion mask 302 is deposited on the top and bottom surfaces of the substrate, and the diffusion mask deposited on the top surface of the substrate 301 is then selectively etched and thus patterned (Fig. 4b).

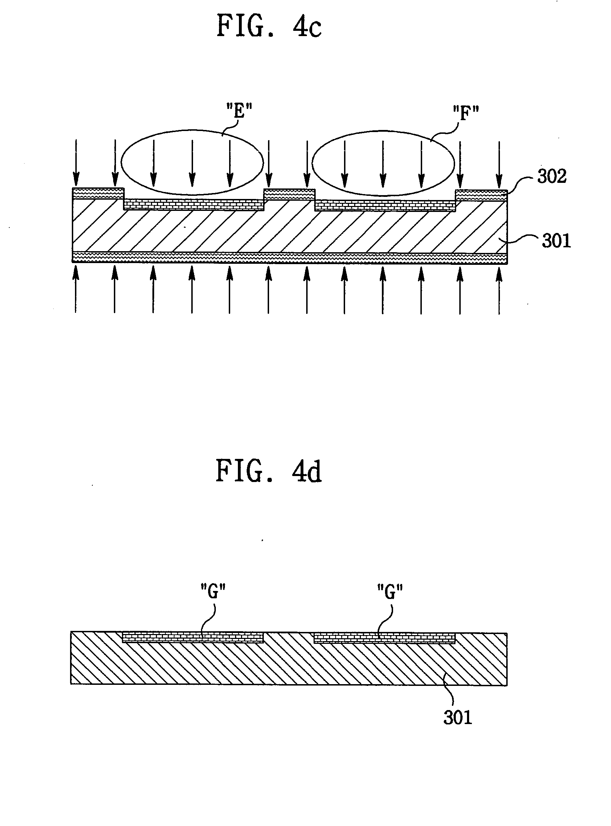

Thereafter, impurities are injected into the substrate 301 masked with the diffusion mask 302, and a diffusion process is then carried out (Fig. 4c).

Here, as shown in Fig. 4c, the impurities, which intend to be injected into the substrate through an area where the diffusion mask 302 remains, are not penetrated into the substrate 301 due to the remaining diffusion mask.

Further, the impunities E and F are injected into the substrate 301 through an area where the diffusion mask 302 is removed.

After the impurities are injected, a diffusion process is performed.

Thereafter, as shown in Fig. 4d, if the diffusion mask 302 is removed, two diffusion areas G are formed on the substrate 301.

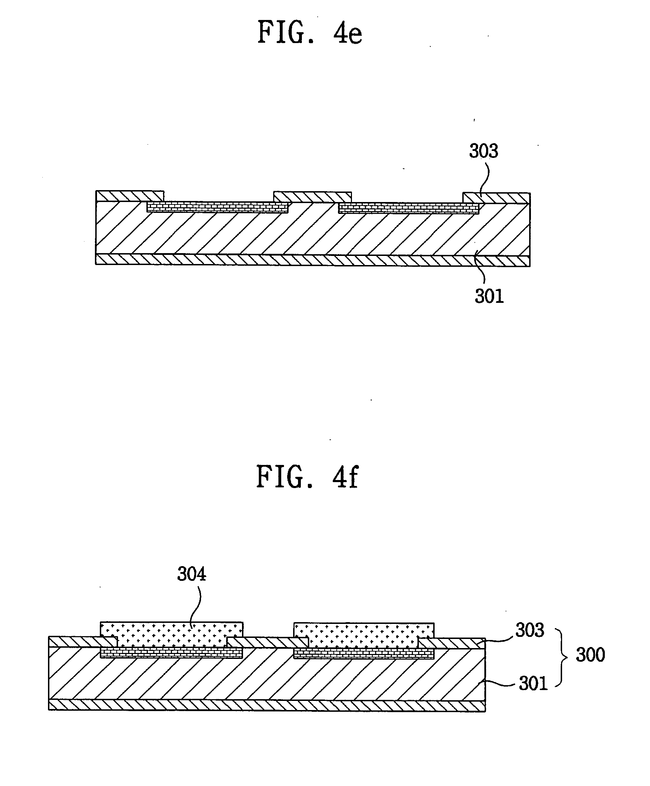

Next, a protective film 303 is formed on the top and bottom surfaces of the substrate in such a manner that the diffusion areas of the substrate 301 can be exposed (Fig. 4e).

Finally, if electrodes 304 are formed on the exposed diffusion areas, the fabrication of a Zener diode is completed (Fig. 4f).

The Zener diode so fabricated is separated into a chip, and then connected in parallel to a device such as a light emitting device, which is vulnerable to static electricity.

Further, in order to connect devices on the top surface of the fabricated Zener diode by means of flip chip mounting, a metal soldering process is carried out and a light emitting device is then bonded on the top surface of the Zener diode.

As described above, since a larger number of process steps are required for the manufacture of the conventional Zener diode, there is a problem in that the manufacturing costs are increased.

### SUMMARY OF THE INVENTION

The present invention is conceived to solve the aforementioned problem in the art. An object of the present invention is to provide a Zener diode for protecting a device vulnerable to static electricity, surge voltage or charge accumulation, and a method for fabricating the Zener diode, wherein a diffusion mask is not needed and the number of process steps can be minimized, thereby enhancing the yield thereof while minimizing the manufacturing costs thereof.

According to a first aspect of the invention for achieving the object, there is provided a method for fabricating a Zener diode, comprising the steps of forming first and second diffusion layers by injecting and diffusing second polar impurities having a polarity different from first polar impurities into top and bottom surfaces of a substrate doped with the first polar impurities; removing the second diffusion layer formed on the bottom surface of the substrate; depositing a protective film on a top surface of the first diffusion layer and removing a part of the protective film to expose a portion of the first diffusion layer; and forming a first electrode on the exposed portion of the first diffusion layer and forming a second electrode on the bottom surface of the substrate.

According to a second aspect of the invention for achieving the object, there is provided a method for fabricating a Zener diode, comprising the steps of forming first and second diffusion layers by injecting and diffusing second polar impurities having a polarity different from first polar impurities into top and bottom surfaces of a substrate doped with the first polar impurities; and forming a first electrode on a top surface of the first diffusion layer and forming a second electrode on a bottom surface of the second diffusion layer.

According to a third aspect of the invention for achieving the object, there is provided a method for fabricating a Zener diode, comprising the steps of preparing a substrate doped with first polar impurities; forming first and second diffusion layers by injecting and diffusing second polar impurities having a polarity different from the first polar impurities into top and bottom surfaces of the substrate; depositing an electrode on a top surface of the first diffusion layer formed on the top surface of the substrate; and selectively removing materials from the electrode to a part of the substrate to allow the electrode and the first diffusion layer to be divided into two parts.

According to a fourth aspect of the invention for achieving the object, there is provided a Zener diode, comprising a substrate doped with first polar impurities; a first diffusion layer formed by diffusing second polar impurities having a polarity different from the first polar impurities into a top surface of the substrate; a protective film deposited on a top surface of the first diffusion layer in a state where a part of the first diffusion layer is exposed; a first electrode formed on the exposed first diffusion layer; and a second electrode formed on a bottom surface of the substrate.

According to a fifth aspect of the invention for achieving the object, there is provided a Zener diode, comprising a substrate doped with first polar impurities; first and second diffusion layers formed by diffusing second polar impurities having a polarity different from the first polar impurities into top and bottom surfaces of the substrate, respectively; a first electrode formed on a top surface of the first diffusion layer; and a second electrode formed at a bottom surface of the second diffusion layer.

According to a sixth aspect of the invention for achieving the object, there is provided a Zener diode, comprising a substrate doped with first polar impurities and including first and second protrusions spaced apart from each other by a groove formed in a top surface of the substrate; a pair of diffusion layers formed by diffusing second polar impurities having a polarity different from the first polar impurities on top surfaces of the first and second protrusions of the substrate, respectively; and a pair of electrodes formed on top surfaces of the pair of diffusion layers, respectively.

### BRIEF DESCRIPTION OF THE DRAWINGS

The above and other objects, features and advantages of the present invention will become apparent from the following description of preferred embodiments given in conjunction with the accompanying drawings, in which:
Fig. 1 is a sectional view of a general light emitting device;
Fig. 2 is an equivalent circuit diagram of a light emitting device and a voltage regulator device;
Figs. 3a to 3g are sectional views explaining a process of fabricating a conventional PN Zener diode;
Figs. 4a to 4f are sectional views explaining a process of fabricating a conventional PNP (NPN) Zener diode;
Figs. 5a to 5f are sectional views explaining a process of fabricating a PN Zener diode according to a first embodiment of the invention;
Figs. 6a to 6d are sectional views explaining a process of fabricating a PNP (or NPN) Zener diode according to a second embodiment of the invention.
Figs. 7a to 7d are sectional views explaining a process of fabricating a PNP (NPN) Zener diode according to a third embodiment of the invention; and
Fig. 8 is a sectional view of a Zener diode according to the third embodiment of the invention.

### DETAILED DESCRIPTION OF THE INVENTION

Hereinafter, preferred embodiments of the invention will be described in detail with reference to the accompanying drawings.

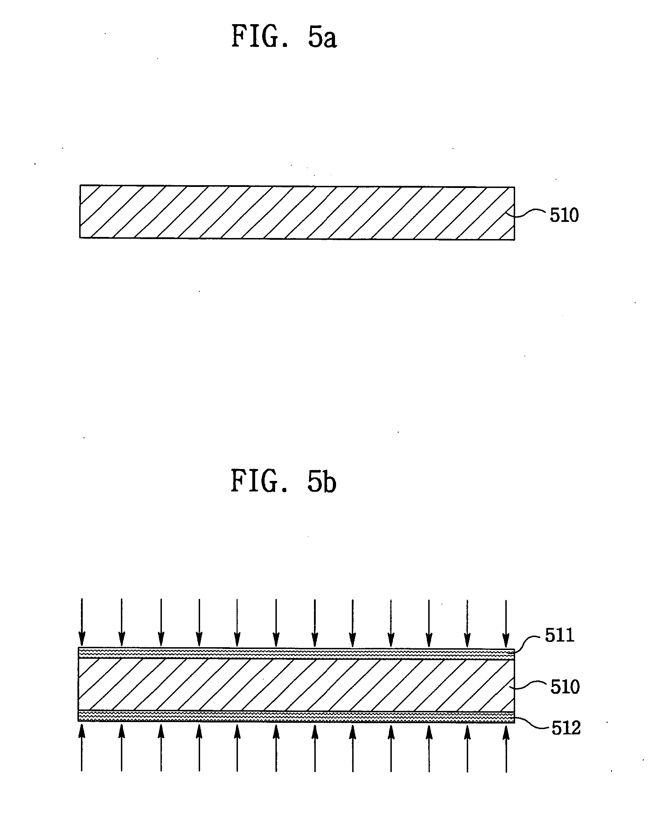

Figs. 5a to 5f are sectional views explaining a process of fabricating a PN Zener diode according to a first embodiment of the invention.

As shown in Fig. 5a, a substrate 510 doped with first polar impurities is first prepared.

Here, it is preferred that the substrate 510 be a silicon substrate.

Thereafter, on the top and bottom surfaces of the substrate 510 are injected and diffused second polar impurities having the polarity different from the first polar impurities, thereby forming first and second diffusion layers 511 and 512 on the top and bottom surfaces of the substrate (Fig. 5b).

Here, according to the present invention, the second polar impurities are injected and diffused into the entire top and bottom surfaces of the substrate 510 without using any diffusion mask.

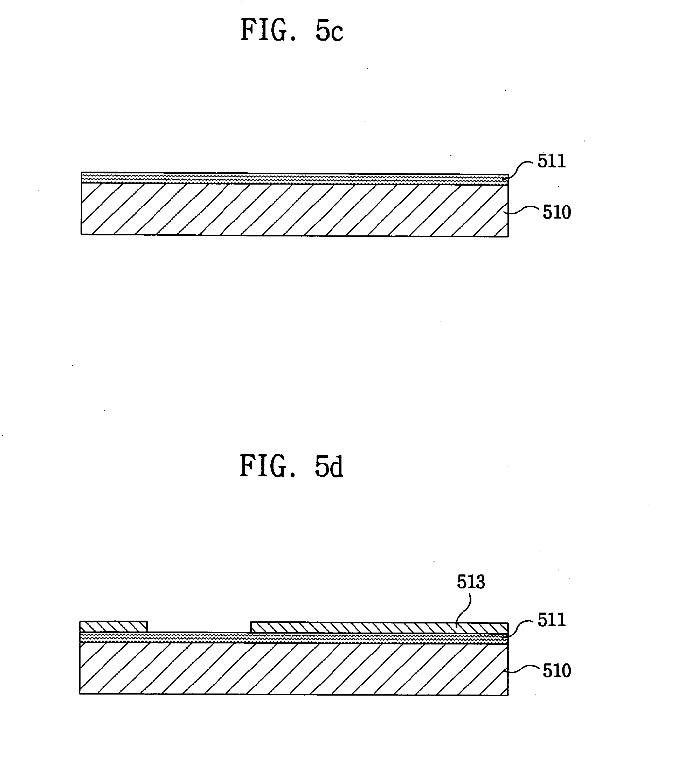

Next, the second diffusion layer 512, which has been formed on the bottom surface of the substrate 510, is removed (Fig. 5c).

The second diffusion layer 512 can be removed by means of a chemical mechanical polishing (CMP) process or a thin film etching process.

Then, on the top of the first diffusion layer 511 of the substrate 510 is deposited a protective film 513, which in turn is partially removed to expose a part of the first diffusion layer 511 (Fig. 5d).

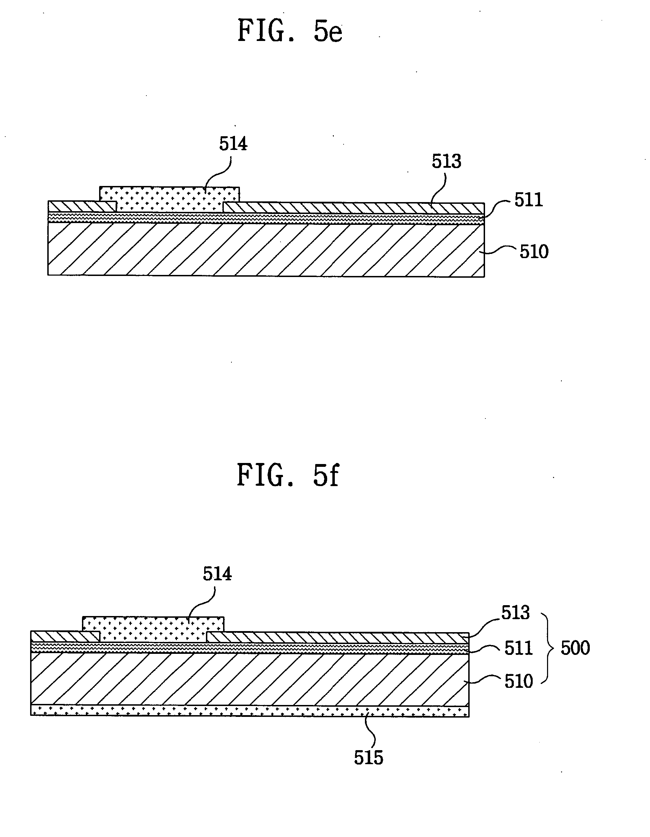

Finally, a first electrode 514 is formed on an exposed portion of the first diffusion layer 511 (Fig. 5e), and a second electrode 515 is formed on the bottom surface of the substrate 510 (Fig. 5f).

In this way, a PN Zener diode, in which the first diffusion layer 511 and the substrate 510 are kept bonded with each other in a state where they have different polarities, is obtained.

That is, if the first diffusion layer 511 is a P-type, the substrate 510 is an N-type. Thus, a PN Zener diode is implemented.

Therefore, the PN Zener diode according to a first embodiment of the invention comprises a substrate 510 doped with first polar impurities, a first diffusion layer 511 formed in such a manner that second polar impurities having the polarity different from the first polar impurities are diffused into the top surface of the substrate 510, a protective film 513 deposited on the top of the first diffusion layer 511 such that a part of the first diffusion layer 511 is exposed, a first electrode 514 formed on an exposed portion of the first diffusion layer 511, and a second electrode 515 formed on the bottom surface of the substra te 510.

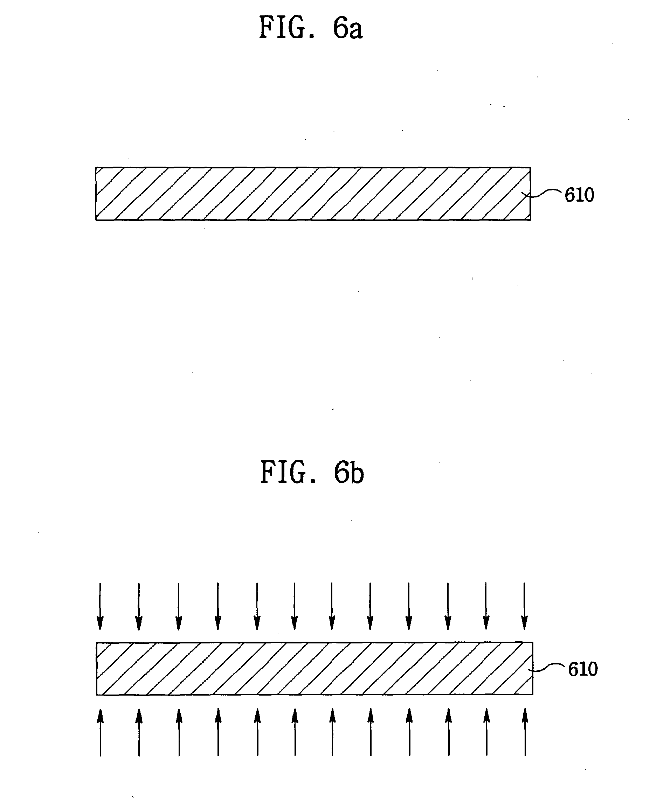

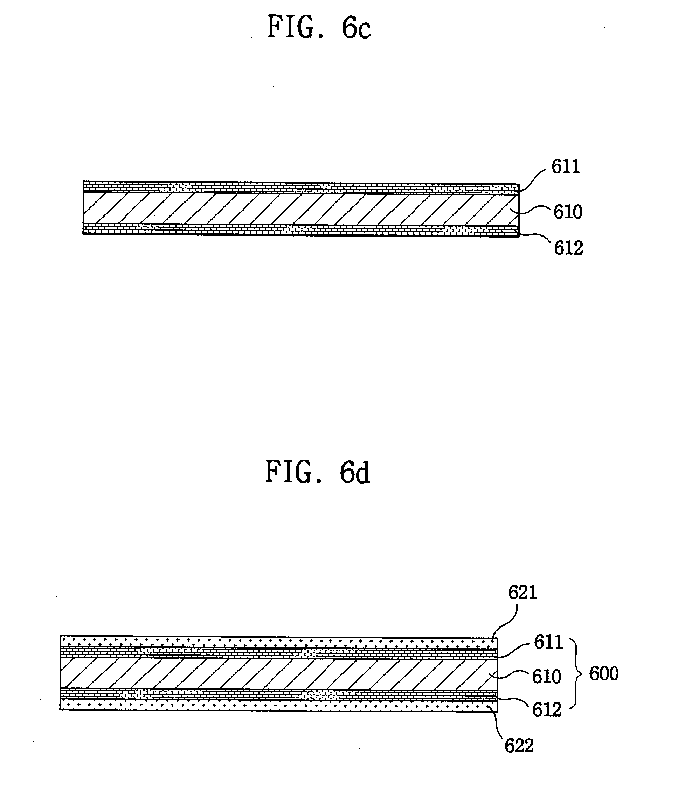

Figs. 6a to 6d are sectional views explaining a process of fabricating a PNP (or NPN) Zener diode according to a second embodiment of the invention. First, into the top surface of a substrate 610 doped with first polar impurities are injected and diffused second impurities having the polarity different from the first polar impurities to form first and second diffusion layers 611 and 612 (Fig. 6a to 6c).

Here, if the first polar impurities are P-type impurities, the second impurities are N-type impurities.

Thereafter, as shown in Fig. 6d, on the top surface of the first diffusion layer 611 is formed a first electrode 621, and on the bottom surface of the second diffusion layer 612 is formed a second electrode 622.

Therefore, a PNP (or NPN) Zener diode comprising the first diffusion layer 611, the substrate 610 and the second diffusion layer 612 is obtained.

Furthermore, in the second embodiment of the invention, a process of forming first and second protective films on the top of the first diffusion layer and the bottom of the second diffusion layer, respectively, and selectively etching some parts of the first and second protective films to expose some parts of the first and second diffusion layers may be provided between the process of forming the first and second diffusion layers and the process of forming the first and second electrodes. Further, the first and second electrodes may be formed on exposed portions of the first and second diffusion layers, thereby fabricating a Zener diode.

Accordingly, such a PNP (or NPN) Zener diode having the bidirectional threshold voltage characteristics may be connected in parallel to a device, such as a light emitting device, to be protected without need to consider the polarities thereof.

By using the method for fabricating a PNP (or NPN) Zener diode according to the second embodiment of the invention, a voltage regulator Zener diode can be fabricated without any thin films (generally made of silicon oxide) and photomasks, which are required for the selective diffusion.

Therefore, the PNP (or NPN) Zener diode according to the second embodiment of the invention comprises a substrate 610 doped with first polar impurities, first and second diffusion layers 611 and 612 formed in such a manner that second polar impurities having the polarity different from the first polar impurities are diffused into the top and bottom surfaces of the substrate 610, a first electrode 621 formed on the top of the first diffusion layer 611, and a second electrode 622 formed on the bottom of the second diffusion layer 6 12.

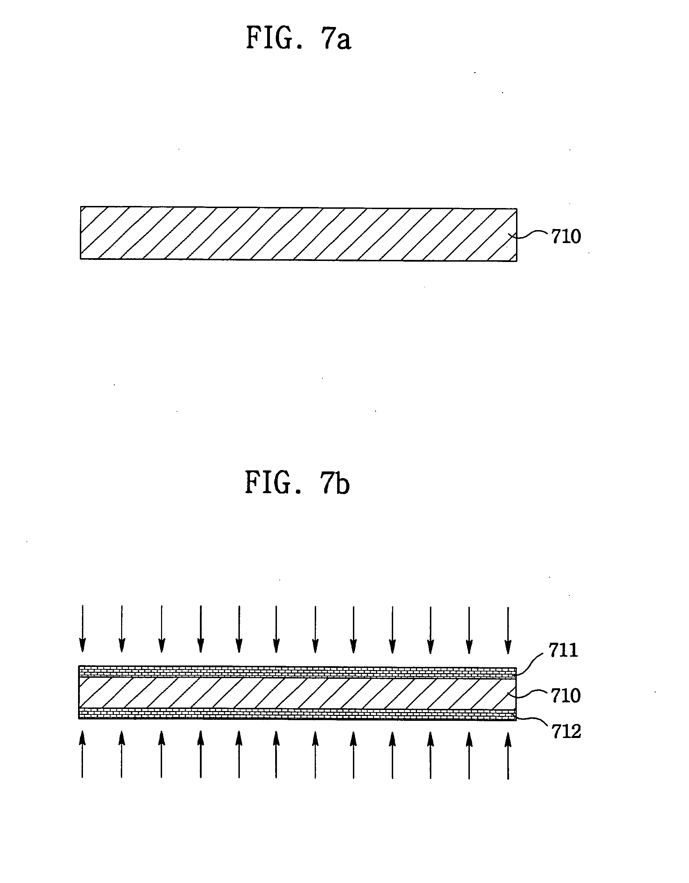

Figs. 7a to 7d are sectional views explaining a process of fabricating a PNP (or NPN) Zener diode according to a third embodiment of the invention. Similar to the previous embodiments, a substrate 710 doped with first polar impurities is first prepared (Fig. 7a).

Next, on the top and bottom surfaces of the substrate 710 are injected and diffused second impurities having the polarity different from the first polar impurities to form first and second diffusion layers 711 and 712 (Fig. 7b).

Preferably, the first and second diffusion layers 711 and 712 are diffusion layers which are obtained by causing the impurities to be diffused over the entire surface of the substrate.

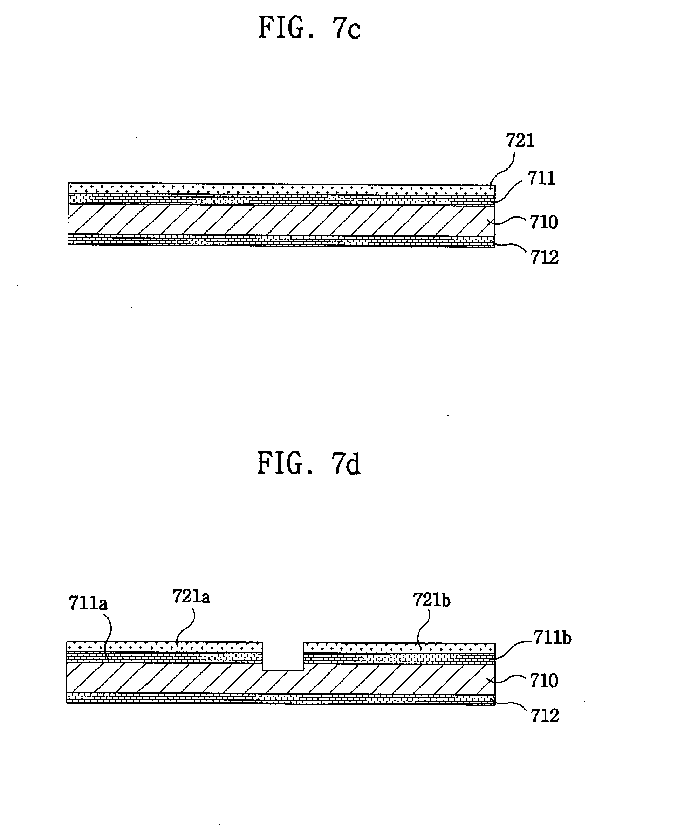

Thereafter, an electrode 721 is deposited on the top of the first diffusion layer 711, which has been formed on the top of the substrate 710 (Fig. 7c).

Then, some materials from the electrode 721 to a part of the substrate 710 are selectively removed to divide the electrode 721 and the first diffusion layer 711 into two parts (Fig. 7d).

Through the aforementioned process, the electrode 721 is divided into two electrodes 721a and 721b, and the first diffusion layer 711 is also divided into two diffusion layers 711 a and 711b.

Therefore, the divided first diffusion layer 711 a, the substrate 710, and the divided first diffusion layer 711 b come to constitute a PNP (or NPN) Zener diode.

Furthermore, in the third embodiment of the invention, a process of forming a protective film on the top of the first diffusion layer and selectively etching two portions of the protective film to form two regions thereof which are spaced apart from each other and through which two portions of the first diffusion layer are exposed, respectively, may be provided between the process of forming the first and second diffusion layers and the process of depositing the electrode. Further, the electrode may be formed on the top of the protective film to come into contact with the exposed portion of the first diffusion layer and some materials from the electrode to a part of the substrate may be removed between the two regions, thereby fabricating a Zener diode.

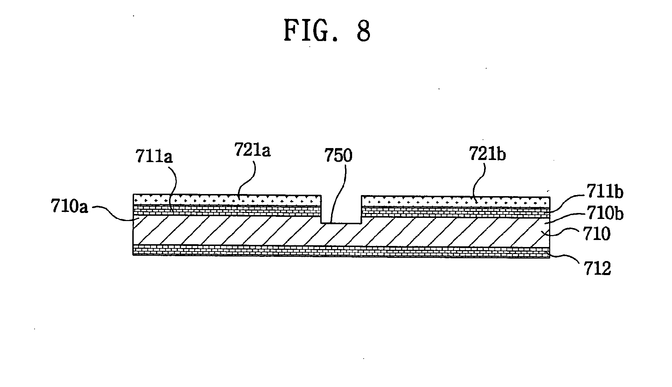

As shown in Fig. 8, the PNP (or NPN) diode according to the third embodiment of the present invention comprises a substrate 710 doped with first polar impurities and including first and second protrusions 710a and 710b spaced apart by a groove 750 formed on the top surface thereof; a pair of diffusion layers 711 a and 711 b formed in such a manner that second polar impurities having the polarity different from the first polar impurities are diffused on the top of the first and second protrusions 710a and 710b of the substrate 710, respectively; and a pair of electrodes 721a and 721b formed on the top of the pair of the diffusion layers 711 a and 711b, respectively.

As described above, a diffusion mask (a silicon oxide film is generally used) that is required in the diffusion process for the fabrication of a Zener diode is not employed in the present invention. Thus, the diffusion mask deposition, photolithography and etching processes can be omitted.

Therefore, a diffusion process is carried out over the entire top and bottom surfaces of a silicon substrate, and a CMP process or dry etching process is then performed to remove the diffusion layer from the bottom surface of the substrate, thereby fabricating a PN Zener diode.

In addition, in a case where a PNP (or NPN) Zener diode having the bidirectional threshold voltage characteristics is to be fabricated, an electrode is formed on the top and bottom surfaces of a substrate without removing the diffusion layer form the top surface of the substrate, thereby fabricating a voltage regulator device.

Furthermore, in a case where a PNP (or NPN) Zener diode having the bidirectional threshold voltage characteristics is to be formed on the same surface of a substrate, a half-cut process is carried out when the device is separated through a dicing process, thereby fabricating a PNP (or NPN) device.

As described above, according to the present invention, a voltage regulator device can be fabricated by carrying out a diffusion process without using a diffusion mask. In addition, a PNP (or NPN) Zener diode having a bi-directional threshold voltage characteristic or a PN Zener diode can be fabricated without any photolithographic process or using the minimum number of processes. Therefore, the number of processing steps can be reduced and the yield thereof can be increased.

Furthermore, an excellent device that can be die bonded can be fabricated at lower manufacturing costs. In a case where the Zener diode of the invention is integrated on the sub mount in a flip-chip process, the effects thereof can be further improved.

Although the present invention have been illustrated and described in connection with the preferred embodiments, it is only for illustrative purposes. It will be readily understood by those skilled in the art that various modifications and changes can be made thereto without departing from the spirit and scope of the present invention defined by the appended claims.

## Claims

1. A method for fabricating a Zener diode, comprising the steps of:
(a) forming first and second diffusion layers by injecting and diffusing second polar impurities having a polarity different from first polar impurities into top and bottom surfaces of a substrate doped with the first polar impurities;
(b) removing the second diffusion layer formed on the bottom surface of the substrate;
(c) depositing a protective film on a top surface of the first diffusion layer and removing a part of the protective film to expose a portion of the first diffusion layer; and
(d) forming a first electrode on the exposed portion of the first diffusion layer and forming a second electrode on the bottom surface of the substrate.

2. A method for fabricating a Zener diode, comprising the steps of:
(a) forming first and second diffusion layers by injecting and diffusing second polar impurities having a polarity different from first polar impurities into top and bottom surfaces of a substrate doped with the first polar impurities; and
(b) forming a first electrode on a top surface of the first diffusion layer and forming a second electrode on a bottom surface of the second diffusion layer.

3. A method for fabricating a Zener diode, comprising the steps of:
(a) preparing a substrate doped with first polar impurities;
(b) forming first and second diffusion layers by injecting and diffusing second polar impurities having a polarity different from the first polar impurities into top and bottom surfaces of the substrate;
(c) depositing an electrode on a top surface of the first diffusion layer formed on the top surface of the substrate; and
(d) selectively removing materials from the electrode to a part of the substrate to allow the electrode and the first diffusion layer to be divided into two parts.

4. The method as claimed in any one of claims 1 to 3, wherein the first polar impurities are P-type impurities and the second polar impurities are N-type impurities.

5. The method as claimed in any one of claims 1 to 3, wherein the substrate includes a silicon substrate.

6. The method as claimed in claim 1, wherein the second diffusion layer is removed through a chemical mechanical polishing (CMP) process or a thin film etching process.

7. The method as claimed in claim 2, further comprising the steps of, between steps (a) and (b), forming a first protective film on a top surface of the first diffusion layer, forming a second protective film on a bottom surface of the second diffusion layer, and selectively etching a part of the first and second protective films to partially expose the first and second diffusion layers,
wherein the first electrode is formed on a top surface of the exposed first diffusion layer, and the second electrode is formed on a bottom surface of the exposed second diffusion layer.

8. The method as claimed in claim 3, further comprising the steps of, between steps (b) and (c), forming a protective film on a top surface of the first diffusion layer and selectively etching two portions of the protective film to form two regions which are spaced apart from each other and through which two portions of the first diffusion layer are exposed, respectively,
wherein the electrode is formed on a top surface of the protective film to come into contact with the exposed first diffusion layer, and materials from the electrode to a part of' the substrate are removed between the two regions to allow the electrode and the first diffusion layer to be divided into two parts.

9. A Zener diode, comprising:
a substrate doped with first polar impurities;
a first diffusion layer formed by diffusing second polar impurities having a polarity different from the first polar impurities into a top surface of the substrate;
a protective film deposited on a top surface of the first diffusion layer in a state where a part of the first diffusion layer is exposed;
a first electrode formed on the exposed first diffusion layer; and
a second electrode formed on a bottom surface of the substrate.

10. A Zener diode, comprising:
a substrate doped with first polar impurities;
first and second diffusion layers formed by diffusing second polar impurities having a polarity different from the first polar impurities into top and bottom surfaces of the substrate, respectively;
a first electrode formed on a top surface of the first diffusion layer; and
a second electrode formed at a bottom surface of the second diffusion layer.

11. A Zener diode, comprising:
a substrate doped with first polar impurities and including first and second protrusions spaced apart from each other by a groove formed in a top surface of the substrate;
a pair of diffusion layers formed by diffusing second polar impurities having a polarity different from the first polar impurities on top surfaces of the first and second protrusions of the substrate, respectively; and
a pair of electrodes formed on top surfaces of the pair of diffusion layers, respectively.

12. The Zener diode as claimed in any one of claims 9 to 11, wherein the first polar impurities are P-type impurities and the second polar impurities are N-type impurities.

13. The Zener diode as claimed in any one of claims 9 to 11, wherein the substrate includes a silicon substrate.
